(19) Europäisches Patentamt
European Patent Office
Office européen des brevets

(11) **EP 3 454 521 A1**

(12) **EUROPÄISCHE PATENTANMELDUNG**

(43) Veröffentlichungstag:
**13.03.2019  Patentblatt 2019/11**

(51) Int Cl.:
***H04L 29/06*** *(2006.01)*

(21) Anmeldenummer: **18000713.0**

(22) Anmeldetag: **05.09.2018**

(84) Benannte Vertragsstaaten:
**AL AT BE BG CH CY CZ DE DK EE ES FI FR GB GR HR HU IE IS IT LI LT LU LV MC MK MT NL NO PL PT RO RS SE SI SK SM TR**
Benannte Erstreckungsstaaten:
**BA ME**
Benannte Validierungsstaaten:
**KH MA MD TN**

(30) Priorität: **08.09.2017   DE 102017008482**

(71) Anmelder: **Airbus Defence and Space GmbH 82024 Taufkirchen (DE)**

(72) Erfinder: **Bodenmüller, Albert 89179 Beimerstetten (DE)**

(74) Vertreter: **Meel, Thomas Airbus Defence and Space GmbH Patentabteilung 88039 Friedrichshafen (DE)**

(54) **VORRICHTUNG UND VERFAHREN ZUR KONVERTIERUNG VON ZEIGER-BASIERTEN ZIELOBJEKT-IDENTIFIKATIONSDATEN**

(57)     Es ist eine Vorrichtung (100) zur Konvertierung von Zielobjekt-Identifikationsdaten im Zeigerformat offenbart. Die Vorrichtung (100) umfasst ein Definitionsmodul (110), in dem zumindest eine der folgenden Konfigurationsinformationen verfügbar ist: Definition/Format der hierarchisch organisierten Referenzen, Definition/Format von einzelnen Wahrscheinlichkeitsvektoren, Zuordnung zwischen hierarchisch organisierten Referenzen und den Wahrscheinlichkeitsvektoren. Die Vorrichtung (100) umfasst außerdem ein Adaptermodul (120), um unter Nutzung des Definitionsmoduls (110) die Zielidentifikationsinformation von einem Zeigerformat in ein Zielformat umzuwandeln, das von einem Wahrscheinlichkeitsvektor definiert ist. Schließlich umfasst die Vorrichtung (100) ein Umkehr-Adaptermodul (130), um unter Nutzung des Definitionsmoduls (110) eine Identifikationsinformation in Form eines Wahrscheinlichkeitsvektors in ein Zeigerformat umzuwandeln.

Fig. 3

**Beschreibung**

Die vorliegende Erfindung bezieht sich auf eine Vorrichtung und ein Verfahren zur Konvertierung von Zielobjekt-Identifikationsdaten im Zeigerformat und Wahrscheinlichkeitsvektorformat, um insbesondere einen Austausch der Zielobjekt-Identifikationsdaten zwischen verschiedenen (militärischen oder zivilen) Führungssystemen zu ermöglichen.

Hintergrund

Zur Erfassung von Zielobjekten innerhalb von Überwachungsbereichen sind Kombinationen verschiedener Sensoren besonders vorteilhaft. Diese Sensoren können beispielsweise eine Radaranlage und/oder einen passiven oder aktiven Lasersensor umfassen, um ein potentielles Zielobjekt zunächst zu detektieren. Weitergehende Information können mittels anderer Sensoreinrichtungen gewonnen werden wie z.B. durch optische Bildsensoren oder elektrooptische Bildsensoren (insbesondere für den sichtbaren oder den infraroten Spektralbereich).

Beispielsweise führen militärische Führungssysteme mittels eines oder mehrerer Sensoren eine Zielobjekt-Identifizierung durch bzw. leiten mittels einer Assoziation von Positionsdaten mit anderen Identifikationsquellen eine Identifizierungsquelleninformation ab. Für solche Führungssysteme gibt es unterschiedliche Methoden diese Identifizierungsinformation intern weiter zu verarbeiten. Dabei ist es üblich, diese Information in Form von zugeordneten Wahrscheinlichkeiten darzustellen und mittels einer Datenverarbeitung weiter zu verarbeiten, beispielsweise als eine Wahrscheinlichkeitsverteilung oder einen Wahrscheinlichkeitsvektor. Ein Austausch von Identifizierungsinformationen kann in Form der Wahrscheinlichkeitsverteilung (z.B. als Wahrscheinlichkeitsvektor) oder als eine Referenz (Zeiger) auf solch eine Wahrscheinlichkeitsverteilung erfolgen. Ein Problem entsteht dadurch, dass unterschiedliche Führungssysteme unterschiedliche Methoden bezüglich des Identifizierungsinformationsaustauschs verwenden.

Die Identifizierung von erfassten Objekten, Zielen, etc. wird in Identifizierungseinrichtungen durchgeführt, die im Folgenden auch als ID-Knoten bezeichnet werden. Häufig sollen auch die Resultate der Identifizierungen zwischen verschiedenen ID-Knoten ausgetauscht werden, wobei solche Identifizierungs- und Klassifizierungs-Sensorergebnisse auch in Form einer Sensor- oder Quellen-spezifischen Wahrscheinlichkeitsverteilung ausgetauscht und verarbeitet werden können. Allerdings werden in anderen Identifizierungsknoten die Identifizierungs- und Klassifizierungs-Sensorergebnisse in Form eines Zeigers ausgetauscht.

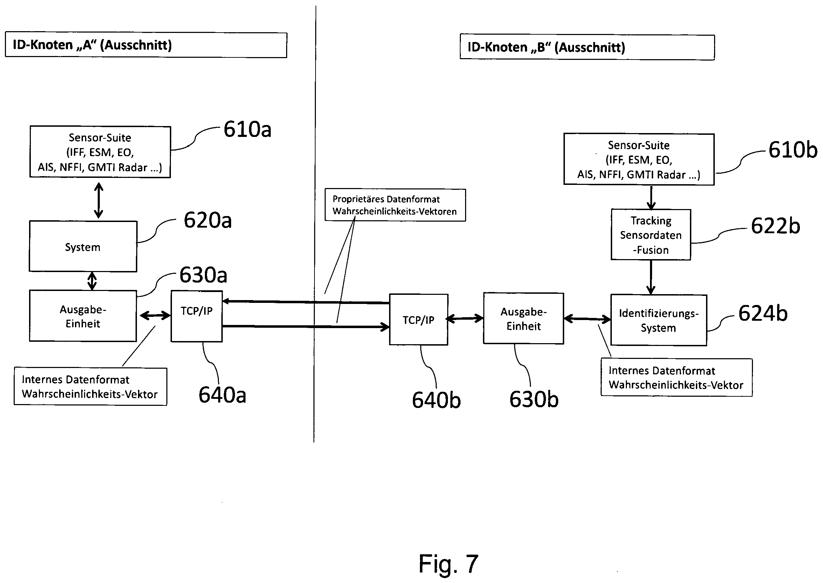

**Fig. 7** zeigt beispielhaft einen bekannten Datenaustausch zwischen einem ID-Knoten A und einem ID-Knoten B, wobei jeweils nur ein Ausschnitt dargestellt ist.

Der ID-Knoten A umfasst beispielhaft eine Sensor-Suite 610a, die verschiedene Arten von Sensoren umfassen kann, ein (Verarbeitungs-) System 620a, eine Ausgabeeinheit 630a und eine Netzwerkeinheit 640a. Das System 620a umfasst beispielsweise einen Mikroprozessor oder eine andere Datenverarbeitungsarchitektur, um die erfassten Sensordaten entsprechend aufzuarbeiten und an die Ausgabeeinheit 630a weiterzuleiten. Das Netzwerksystem 640a bereitet die ausgegebenen Daten beispielsweise vor, um unter Nutzung eines internen Datenformates (z.B. der Nutzung einer TCP/IP Verbindung) diese Daten zu übermitteln.

Der ID-Knoten B umfasst ebenfalls eine Sensor-Suite 610b, eine Sensordatenfusionseinheit 622b, ein Identifizierungssystem 624b, eine Ausgabeeinheit 630b und ebenfalls eine Netzwerkeinheit 640b. Die Sensor-Suite 610b umfasst wiederum einen oder mehrere Sensoren, deren Sensorsignale an eine Sensordatenfusionseinheit 622b weitergeleitet werden, in der alle Sensordaten entsprechend erfasst und verarbeitet werden. In dem Identifizierungssystem 624b kann beispielhaft die Identifizierung der erfassten Objekte erfolgen. Unter Nutzung eines internen Datenformates können die Resultate an die Ausgabeeinheit 630b weiterleitet werden, die wiederum die Daten an die Netzwerkeinheit 640b leitet, um dort unter Nutzung einer beispielhaften TCP/IP-Verbindung die Daten zu übertragen.

Der Datenaustausch von ID-Knoten A zu dem ID-Knoten B und von ID-Knoten B zu dem ID-Knoten A kann beispielhaft über eine TCP/IP Verbindung erfolgen, wobei zwischen den Knoten A und B ein proprietäres Datenformat genutzt wird, welches dazu geeignet ist, die internen Zwischenergebnisse in Form geeigneter Wahrscheinlichkeitsverteilungen von Knoten A an Knoten B und umgekehrt von Knoten B an Knoten A zu senden.

Ein Beispiel für eine Identifizierungsinformation ist eine Sensor- bzw. Quellen-spezifischen Wahrscheinlichkeitsverteilung, die wie folgt angegeben werden kann:

$$V_1 = [p(D_{\text{Flugplan}} | \text{Flugziel fliegt konform zu Flugplan}), p(D_{\text{Flugplan}} | \text{Flugziel fliegt nicht konform zu Flugplan})] := [0.85, 0.15],$$

wobei p die Wahrscheinlichkeit für das Ereignis in der Klammer darstellt. In dem Identifizierungssystem 624b kann die Interpretation und Zuordnung zu Freund/Feind/Neutral Kategorien erfolgen. Als Resultat erhält man aus der obigen Wahrscheinlichkeitsverteilung beispielsweise eine neue interpretierte Wahrscheinlichkeitsverteilung :

$$V_2 = [p(\text{Freund zivil}), p(\text{Freund militärisch}), p(\text{Feindlich zivil}), p(\text{Feindlich militärisch}), p(\text{Neutral zivil}), p(\text{Neutral militärisch})]$$

$$:= [0.7, 0.1, 0.05, 0.05, 0.05, 0.05].$$

Eine solche Wahrscheinlichkeitsverteilung lässt sich mathematisch prinzipiell immer als n-Tupel darstellen (aus Gründen der einfacheren Lesbarkeit und Unterscheidung von den bedingten Wahrscheinlichkeiten werden hier eckige Klammern für die Wahrscheinlichkeiten verwendet).

Beide Systeme am ID-Knoten A und am ID-Knoten B sind gleichartig, in dem Sinn, dass die Identifizierungsinformation als Wahrscheinlichkeitsvektoren ausgetauscht werden. Insbesondere kann jeder der Identifizierungsknoten A und B ein militärisches Führungssystem sein, die intern zur Berechnung des wahrscheinlichsten Identifizierungsergebnisses mit Wahrscheinlichkeitsverteilungen arbeiten, die zwischen den unterschiedlichen möglichen Identitäten unterscheidet.

In dem gezeigten Beispiel ist der ID-Knoten B beispielsweise in der Lage, seine eigenen gewonnenen Informationen, die von den Ergebnissen der Sensoren seiner eigenen Sensor-Suite 610b vorliegen, mit den zusätzlichen Informationen, die von den Ergebnissen der Sensoren der Sensor-Suite 610a von ID-Knoten A empfangen wurden, nicht nur abzugleichen, sondern auch zu ergänzen oder zu fusionieren. Auf diese Weise wird ein umfassenderes Lagebild erhalten. Da dies ebenfalls in Gegenrichtung umgesetzt werden kann, haben beide ID-Knoten A und B ein umfassenderes und abgeglichenes Lagebild und dadurch weniger oder keine Widersprüche zu einander.

Oft kommt es aber auf Grund unterschiedlicher Technologien für den Austausch der Identifizierungs- und Klassifizierungs-Sensorergebnisse zu Schnittstellenproblemen. Dies ist zum Beispiel in Situationen der Fall, wenn mehrere Identifizierungseinrichtungen (z.B. ein Führungseinsatzsystem (FüWES) einer Fregatte und ein Boden-basiertes Luftverteidigungssystem) zusammengeschaltet werden, um ihre jeweiligen Identifizierungs- und Klassifizierungsergebnisse ihrer unterschiedlichen Sensoren und Quellen auszutauschen, um damit die Fusion eigener Sensorergebnisse mit denen des externen System oder mehrerer externer Systeme zu ermöglichen, um so ein umfassenderes Taktisches Lagebild zu erhalten und daraus resultierend zu einer verlässlicheren Identifizierung bzw. Klassifizierung zu gelangen.

Bei den Schnittstellenproblemen steht an erster Stelle die rein technische (physikalische) Verbindung zwischen mindesten zwei solcher Identifizierungseinrichtungen. Diese technische (physikalische) Verbindung kann beispielsweise als Kabelgebundene Schnittstelle (z.B. serielle HDLC Verbindung, Ethernet-Verbindung oder Parallelschnittstelle) ausgeführt sein, aber auch als Datenfunk-Schnittstelle (z.B. Bluetooth-Technologie, WLAN-Technologie, Richtfunk, Satelliten-basierte Datenschnittstelle) oder als optische Schnittstelle (z.B. Lichtwellenleiter, Laserbasierte Datenübertragung) usw.

Aber unabhängig von diesem reinen Informationsaustausch gemäß ISO/OSI Schichtenmodell Schicht 1 und 2, also der rein technischen Art der Datenverbindung, werden häufig unterschiedliche Middleware-Technologien verwendet, um diese Daten innerhalb des jeweiligen Systems an die unterschiedlichen Prozesse zu übermitteln. Des Weiteren existieren für den Datenaustausch bei zivilen und militärischen Systemen unterschiedliche Daten- und Meldungsformate, welche geeignet sind den Austausch von Identifizierungs- und Klassifizierungs-Informationen zwischen unterschiedlichen Systemen zu ermöglichen. Beispielhaft können hier die folgenden Formate genannt werden:

1. Daten von Flugsicherungssystemen oder auch von Sensoren, die mit Flugsicherungssystemen verbunden werden, werden häufig im ASTERIX (All Purpose Structured Eurocontrol Surveillance Information Exchange; engl.) Datenformat ausgetauscht. Das ASTERIX Format und Daten-Protokoll ist ein von der Europäischen Flugsicherung EUROCONTROL veröffentlichtes Protokoll für den Austausch von Flugüberwachungsdaten. Dies wird sowohl zivil wie auch militärisch genutzt.

2. Für den militärischen Datenaustausch werden unterschiedliche sogenannte Taktische Daten Links (TDL) genutzt. Die Meldungsformate, Inhalte und das Kommunikationsprotokoll zwischen den TDL Nutzern sind in NATO Standards definiert, wobei hier beispielhaft die Folgenden genannt werden sollen: "Tactical Data Link-16", "Tactical Data Link-22" und Joint Range Extension Applications Protocol (JREAP).

3. Für den militärischen Datenaustausch zwischen verschiedenen NATO Partnern gleicher und verschiedener Nationen auf unterschiedlichen Meldungshierarchien wird auch das sog. ADatP-3 (Allied Data Publication No 3) Format verwendet.

4. Nato Intelligence, Surveillance And Reconnaissance Tracking Standard (NITS).

Da bereits technische Systeme basierend auf der Nutzung und Austausch der Wahrscheinlichkeitsverteilung in Betrieb sind (siehe Fig. 7), ist derzeit die technische Möglichkeit zum Aufbau eines Identifizierungsverbundes mittels Austausch ihrer jeweiligen Identifizierungs- und Klassifizierungsergebnisse ihrer unterschiedlichen Sensoren und Quellen als Zeiger nicht gegeben.

Daher ist eine technische Lösung zum Austausch von Identifizierungsinformationen zwischen Stationen, die mit Wahrscheinlichkeitsverteilung arbeiten, und Stationen, die mit Zeiger-Information arbeiten, wünschenswert. Insbesondere besteht ein Bedarf nach Systemen, die zumindest ein Teil der oben genannten Schnittstellenprobleme vermeiden.

Zusammenfassung

Zumindest ein Teil der obengenannten Probleme wird durch eine Vorrichtung zur Konvertierung von Zielobjekt-Identifikationsdaten in einem Zeigerformat nach Anspruch 1 und eine Verfahren nach Anspruch 10 gelöst. Die abhängigen Ansprüche definieren weitere vorteilhafte Ausführungsformen.

Die vorliegende Erfindung bezieht sich auf eine Vorrichtung zur Konvertierung von Ziel-Identifikationsdaten in einem Zeigerformat. Das Zeigerformat ist durch Zeiger auf vorab definierte und gespeicherte hierarchisch organisierte Referenzen auf Sensor- oder Quellen-spezifischen Wahrscheinlichkeitsverteilungen definiert. Die Vorrichtung umfasst ein Definitionsmodul, in dem zumindest eine der folgenden Konfigurationsinformationen verfügbar ist:

- Definition der hierarchisch organisierten Referenzen,
- Format der hierarchisch organisierten Referenzen,
- Definition von einzelnen Wahrscheinlichkeitsvektoren,
- Format von einzelnen Wahrscheinlichkeitsvektoren,
- Zuordnung der hierarchisch organisierten Referenzen zu den Wahrscheinlichkeitsvektoren,
- Zuordnung der Wahrscheinlichkeitsvektoren zu den hierarchisch organisierten Referenzen.

Außerdem umfasst die Vorrichtung ein Adaptermodul, das ausgebildet ist, um unter Nutzung des Definitionsmoduls die Zielobjekt-Identifikationsdaten von einem Zeigerformat in ein Zielformat zu konvertieren, wobei das Zielformat ein Wahrscheinlichkeitsvektorformat ist, das durch zumindest einen Wahrscheinlichkeitsvektor definiert ist (z.B. Wahrscheinlichkeits-basierten Quelleninformationsdaten umfasst). Schließlich umfasst die Vorrichtung ein Umkehr-Adaptermodul, das ausgebildet ist, um unter Nutzung des Definitionsmoduls die Ziel-Identifikationsdaten in Form eines Wahrscheinlichkeitsvektors in das Zeigerformat zu konvertieren.

Im Rahmen der vorliegenden Erfindung beziehen sich Zielobjekt-Identifikationsdaten (oder Ziel-Identifikationsdaten) auf alle Informationen, die nutzbar sind (z.B. in militärischen oder zivilen Führungssystemen), um ein von Sensoren erfasstes Zielobjekt zu identifizieren oder zu klassifizieren.

Optional ist das Definitionsmodul ausgebildet, um interne Datenobjekte, Datenstrukturen und interne Verknüpfungen des Adaptermoduls anhand einer Konvertierungsvorschrift abzuleiten und in eine für das Adaptermodul bearbeitbare Form umzuwandeln. Das Definitionsmodul kann auch ausgebildet sein, um interne Datenobjekte, Datenstrukturen und interne Verknüpfungen des Umkehr-Adaptermoduls anhand einer Konvertierungsvorschrift abzuleiten und in eine für das Umkehr-Adaptermodul bearbeitbare Form umzuwandeln.

Optional umfasst das Definitionsmodul ein erstes Definitionsmodul und ein zweites Definitionsmodul, wobei das erste Definitionsmodul Definitionen für das Adaptermodul bereitstellt und das zweite Definitionsmodul Definitionen für den Umkehradapter bereitstellt.

Optional umfasst die Vorrichtung einen Speicher, um die Konfigurationsinformationen für das Definitionsmodul zu speichern, insbesondere in einem XML-Format. Die gespeicherten Informationen können zumindest eine der folgenden Informationen umfassen:

- Definition hierarchisch organisierter Zeiger,
- Definition von Wahrscheinlichkeitsvektoren,
- Zuordnung der Zeiger zu den Wahrscheinlichkeitsvektoren,
- Zuordnung der Wahrscheinlichkeitsvektoren zu den Zeigern.

Optional umfasst die Vorrichtung eine Netzwerkschnittstelle, um auf eine externe Datenbank, die die Konfigurationsinformationen bereitstellt, zugreifen zu können.

Das Definitionsmodul kann daher auch ausgebildet sein, um die Konfigurationsinformationen von der externen Datenbank zu laden.

Optional ist das Adaptermodul und/oder das Umkehr-Adaptermodul ausgebildet, um ein internes Datenformat zu nutzen und die Vorrichtung umfasst weiter ein erstes Fassaden-Modul, das ausgebildet ist, um eine physikalische Schnittstellenanbindung an eine externe Datenschnittstelle und eine Konvertierung zwischen empfangenen Daten im Zeigerformat und Daten in dem intern genutzten Datenformat bereitzustellen. Die Vorrichtung kann außerdem ein zweites Fassaden-Modul umfassen, das ausgebildet ist, um die physikalische Schnittstellenanbindung an eine weitere Datenschnittstelle und eine Konvertierung zwischen empfangenen Daten im Wahrscheinlichkeitsvektorformat und Daten in dem intern genutzten Datenformat bereitzustellen.

Ausführungsbeispiele beziehen sich auch auf eine Zielobjekt-Identifizierungseinrichtung (ID-Knoten) mit einer Schnittstelle zum Empfangen oder Übermitteln von Informationen an externe ID-Knoten, wobei die Schnittstelle eine der zuvor genannten Vorrichtungen aufweisen kann.

Ausführungsbeispiele beziehen sich auch auf ein System mit einer ersten Identifizierungseinrichtung und einer zweiten Identifizierungseinrichtung. Die erste Identifizierungseinrichtung oder die zweite Identifizierungseinrichtung können eine Vorrichtung, wie sie zuvor definiert wurde, aufweisen.

Die vorliegende Erfindung bezieht sich auch auf ein Verfahren zur Konvertierung von Zielobjekt-Identifikationsdaten im Zeigerformat. Das Verfahren umfasst ein Bereitstellen einer Definitionsdatei mit zumindest einer der folgenden Informationen:

- Definition der hierarchisch organisierten Referenzen,
- Format der hierarchisch organisierten Referenzen,
- Definition von einzelnen Wahrscheinlichkeitsvektoren,
- Format von einzelnen Wahrscheinlichkeitsvektoren,
- Zuordnung der hierarchisch organisierten Referenzen zu den Wahrscheinlichkeitsvektoren,
- Zuordnung der Wahrscheinlichkeitsvektoren zu den hierarchisch organisierten Referenzen.

Das Verfahren umfasst weiter einen Schritt des Umwandelns. Das Umwandeln kann eines der folgenden Schritte sein:

(i) ein Konvertieren von Zielobjekt-Identifikationsdaten von einem Zeigerformat in ein Wahrscheinlichkeitsvektorformat, das durch einen oder mehreren Wahrscheinlichkeitsvektoren definiert ist, wobei die bereitgestellten Informationen zum Konvertieren genutzt werden; oder

(ii) ein Konvertieren von Zielobjekt-Identifikationsdaten in Form eines Wahrscheinlichkeitsvektors in das Zeigerformat, wobei die bereitgestellten Informationen zum Konvertieren genutzt werden.

Dieses Verfahren oder zumindest Teile davon kann/können ebenfalls in Form von Anweisungen in Software oder auf einem Computerprogrammprodukt implementiert oder gespeichert sein, wobei gespeicherte Anweisungen in der Lage sind, die Schritte nach dem Verfahren auszuführen, wenn das Verfahren auf einem Prozessor läuft. Daher bezieht sich die vorliegende Erfindung ebenfalls auf Computerprogrammprodukt mit darauf gespeichertem Software-Code (Softwareanweisungen), der ausgebildet ist, um eines der zuvor beschriebenen Verfahren auszuführen, wenn der Software-Code durch eine Verarbeitungseinheit ausgeführt wird. Die Verarbeitungseinheit kann jede Form von Computer oder Steuereinheit sein, die einen entsprechenden Mikroprozessor aufweist, der einen Software-Code ausführen kann.

Ein besonders vorteilhaftes Ausführungsbeispiel bezieht sich auch auf eine Einrichtung zur Adaption und Umwandlung von Zeiger-basierten externen Ziel-Identifikationsdaten in Wahrscheinlichkeits-basierte Quelleninformationsdaten einer beliebigen Middleware und umgekehrt. Die Einrichtung umfasst ein Adaptermodul, das eine abstrakte hierarchisch organisierte Referenz (Zeiger) einer Zielidentifikationsinformation in das Zielformat eines Wahrscheinlichkeitsvektors umwandelt. Die Einrichtung umfasst weiter ein Revers-Adaptermodul (Umkehr-Adaptermodul), das eine Zielidentifikationsinformation in Form eines Wahrscheinlichkeitsvektors in das Zielformat einer abstrakten hierarchisch organisierten Referenz (Zeiger) umwandelt. Schließlich umfasst die Einrichtung ein Definitionsmodul in dem die Konfiguration mit folgenden Informationen einlesbar ist:

- Definition und Format der hierarchisch organisierten Referenzen (Zeiger),
- Definition und Format der einzelnen Wahrscheinlichkeitsvektoren,
- Zuordnung der hierarchisch organisierten Referenzen (Zeiger) zu den Wahrscheinlichkeitsvektoren,
- Zuordnung der Wahrscheinlichkeitsvektoren zu den hierarchisch organisierten Referenzen (Zeiger).

Optional ist ein Zeiger-Fassaden-Modul für die physikalische Schnittstellenanbindung an die externe Datenschnittstelle (ID Knoten "A") und Umwandlung des empfangenen Datenstroms in die intern genutzte Plattform Middleware und umgekehrt vorgesehen. Außerdem kann optional ein Wahrscheinlickeitsvektor-Fassaden-Modul vorgesehen sein für die physikalische Schnittstellenanbindung an die Ziel Datenschnittstelle (ID Knoten "B") und Umwandlung des empfangenen Datenstroms in die intern genutzte Plattform Middleware und umgekehrt.

Das Definitionsmodul kann die Adapter-internen Datenobjekte, Datenstrukturen und internen Verknüpfungen anhand der Konvertierungsvorschrift (Anteil Konvertierungsvorschrift von Identifizierungsinformation im Zeigerformat in das Wahrscheinlichkeitsvektor-Format) ableiten und in eine für das Adaptermodul bearbeitbare Form wandeln. Das Revers-Definitionsmodul (oder UmkehrDefinitionsmodul) kann die Revers-Adapter-internen Datenobjekte, Datenstrukturen und internen Verknüpfungen anhand der Konvertierungsvorschrift (Anteil Konvertierungsvorschrift von Wahrscheinlichkeitsvektor-Format in Identifizierungsinformation im Zeigerformat) ableiten und in eine für das Revers-Adaptermodul bearbeitbare Form wandeln.

Ausführungsbeispiele umfassen insbesondere Schnittstellen zur Datenkommunikation zwischen zwei ID-Knoten oder können dort softwarebasiert implementiert sein.

Vorteile von Ausführungsbeispielen ergeben sich insbesondere aus der Möglichkeit Ziel-Identifikationsdaten auszutauschen, und zwar unabhängig von den genutzten Formaten in zivilen und militärischen Führungssystemen.

Kurzbeschreibung der Figuren

Die Ausführungsbeispiele der vorliegenden Erfindung werden besser verstanden anhand der folgenden detaillierten Beschreibung und den beiliegenden Zeichnungen der unterschiedlichen Ausführungsbeispiele, die jedoch nicht so verstanden werden sollten, dass sie die Offenbarung auf die spezifischen Ausführungsformen einschränken, sondern lediglich der Erklärung und dem Verständnis dienen.

Fig. 1    veranschaulicht beispielhaft das genutzte Zeigerformat.

Fig. 2    zeigt eine Vorrichtung zur Konvertierung von Ziel-Identifikationsdaten im Zeigerformat gemäß einem Ausführungsbeispiel der vorliegenden Erfindung.

Fig. 3    zeigt ein Ausführungsbeispiel der vorliegenden Erfindung für einen Datenaustausch zwischen zwei ID-Knoten mittels Zeigerinformation und Konvertierung in Wahrscheinlichkeits-Vektoren

Fig. 4    zeigt eine Anwendung der erfindungsgemäßen Vorrichtung für eine Datenkonvertierung zwischen einem Flugsicherungssystem und einem Führungssystem.

Fig. 5    zeigt eine Anwendung der erfindungsgemäßen Vorrichtung für eine Datenkonvertierung von einem extern-angebundenen Führungssystem und einem zweiten Führungssystem.

Fig. 6    zeigt ein Flussdiagramm für ein Verfahren zur Konvertierung von Ziel-Identifikationsdaten im Zeigerformat gemäß einem Ausführungsbeispiel der vorliegenden Erfindung.

Fig. 7    stellt einen konventionellen Datenaustausch einer Wahrscheinlichkeitsverteilung zwischen zwei beispielhaften ID-Knoten dar.

Detaillierte Beschreibung

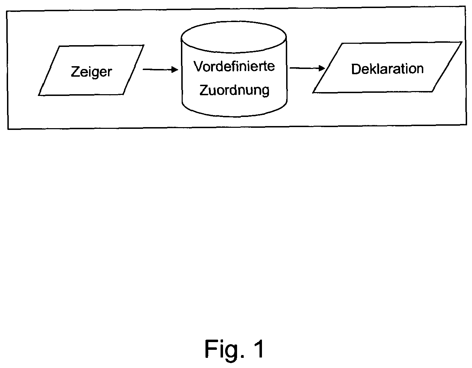

Die **Fig. 1** veranschaulicht beispielhaft das genutzte Zeigerformat, bei dem ein Zeiger auf eine vordefinierte Zuordnung zeigt, wobei die vordefinierte Zuordnung beispielsweise eine bestimmte Wahrscheinlichkeitsverteilung darstellt und über eine entsprechende Deklaration vorbestimmt ist. Der Zeiger kann dabei auf verschiedenste vorbestimmte Wahrscheinlichkeitsverteilungen zeigen, um so die Identifizierungsinformation darzustellen.

Der Zeiger, der auf vorab definierte und gespeicherte hierarchisch organisierte Referenzen zeigt, kann wie folgt gegeben sein:

$$Z = \text{Deklarationsnummer; Konfidenzmaß} := 01001; 01$$

oder

$$Z = \text{Quellennummer; Deklarationsnummer; Konfidenzmaß}$$

$$:= 003; 01001; 01$$

Die verschiedenen Sensor-spezifischen und Quellen-spezifischen Wahrscheinlichkeitsverteilungen werden alle mit einer eigenen Deklarationsnummer versehen. Der Zeiger Z gibt nun diese Deklarationsnummer an und wählt dadurch aus der Vielzahl von Wahrscheinlichkeitsverteilungen eine aus. Außerdem gibt der Zeiger Z ein Konfidenzmaß an, das ein Maß für die Zuverlässigkeit/Richtigkeit der Wahrscheinlichkeitsverteilung ist (z.B. unter welchen Bedingungen die Sensordaten erfasst wurden; z.B. können schlechte Witterungsbedingungen die Sensorerfassung erschweren).

Außerdem kann der Zeiger optional eine Quellennummer angeben, die die Sensorquelle identifiziert (zum Beispiel einen bestimmten Radarsensor oder ein bestimmtes Objekt identifiziert).

Der Vorteil der Übertragung von Zeigern liegt in der geringeren benötigten Datenbandbreite für Daten, da die Länge des Wahrscheinlichkeitsvektors in der Regel deutlich mehr Speicher und damit eine deutlich höhere Datenbandbreite benötigt. Sogenannte Track Management-Daten (z.B. Zielnummer, Zeitstempel usw.) fallen bei beiden Datenaustauschverfahren gleichermaßen an, sind aber hier nicht genannt. Die eigentlichen Identifizierungsinformationen sind die Quellennummer, Deklarationsnummer und das Konfidenzmaß.

Daraus ergibt sich das Problem, dass unterschiedliche Identifizierungs- und Klassifizierungs-Sensorergebnisse, obwohl sie semantisch miteinander vergleichbar und damit miteinander fusionierbar wären, nicht ohne weitere Verarbeitung fusioniert werden können. Zum Beispiel liegt eine Information schon in geeigneter Form einer Wahrscheinlichkeitsverteilung vor, während die andere nur indirekt eine Referenz auf eine Wahrscheinlichkeitsverteilung darstellt.

Bei konventionellen Systemen kann zwar eine Umwandlung solcher Zeiger (Referenzen) in eine Wahrscheinlichkeitsverteilung für eine bestimmte Aufgabenstellung spezifisch umgesetzt werden, aber diese Zuordnung ist starr und unveränderlich, was deren Nutzung einschränkt. Häufig kommt es aus technischer Sicht zu Veränderungen, wenn z.B. zusätzlich oder neue Sensoren in einem System nachgerüstet werden oder deren technische Fähigkeiten verbessert werden. Daher ist diese starre Zuordnung von konventionellen Systemen nicht mehr korrekt ist.

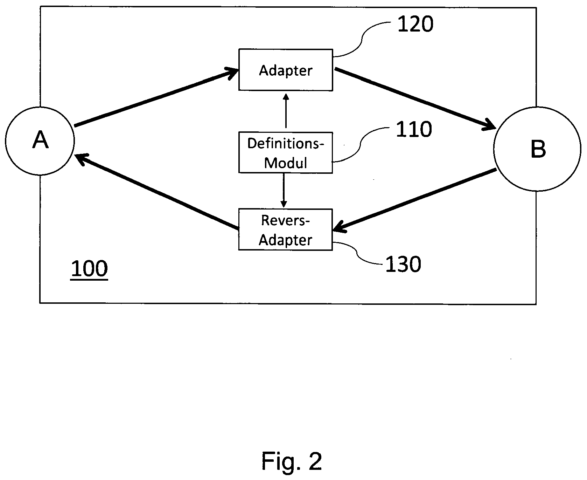

**Fig. 2** zeigt eine Vorrichtung 100 gemäß einem Ausführungsbeispiel der vorliegenden Erfindung, die dieses Problem löst und den Datenaustausch zwischen zwei Knoten A und B erlaubt. Die Vorrichtung ist zur Konvertierung von Zielobjekt-Identifikationsdaten (oder Ziel-Identifikationsinformationen) im Zeigerformat geeignet, wobei das Zeigerformat durch Zeiger auf vorab definierte und gespeicherte hierarchisch organisierte Referenzen auf Sensor- oder Quellenspezifischen Wahrscheinlichkeitsverteilungen definiert ist. Die Vorrichtung umfasst ein Definitionsmodul 110, in dem zumindest eine der folgenden Konfigurationsinformationen verfügbar ist:

- Definition und/oder Format der hierarchisch organisierten Referenzen,
- Definition und/oder Format von einzelnen Wahrscheinlichkeitsvektoren,
- Zuordnung der hierarchisch organisierten Referenzen zu den Wahrscheinlichkeitsvektoren,
- Zuordnung der Wahrscheinlichkeitsvektoren zu den hierarchisch organisierten Referenzen.

Die Vorrichtung umfasst außerdem ein Adaptermodul 120, das ausgebildet ist, um unter Nutzung des Definitionsmoduls 110 die hierarchisch organisierte Zeiger-basierte Zielobjekt-Identifikationsdaten in ein Zielformat umzuwandeln, das von einem Wahrscheinlichkeitsvektor definiert ist. Schließlich umfasst die Vorrichtung ein Umkehr-Adaptermodul 130, das ausgebildet ist, um unter Nutzung des Definitionsmoduls 110 eine Ziel-Identifikationsdaten in Form eines Wahrscheinlichkeitsvektors in ein Zielformat umzuwandeln, das auf einem hierarchisch organisierten Zeiger basiert.

Gemäß Ausführungsbeispielen der vorliegenden Erfindung sind alle Definitionen, die zur Umwandlung der Identifikationsinformationen erforderlich sind, in einer Definitionsdatei definiert. Insbesondere ist es nicht erforderlich, dass das Adaptermodul 120 oder das Umkehr-Adaptermodul 130 diese Konfigurationsinformationen bereits integriert haben müssen. Vielmehr kann die Vorrichtung 100 einen Speicher umfassen, in dem die Konfigurationsinformationen gespeichert sind, sodass das Definitionsmodul 110 darauf zugreifen kann. Diese Definitionsdatei kann flexibel angepasst werden. Es ist ebenfalls möglich, dass die Definitionsdatei von einer externen Datenbank bei Bedarf heruntergeladen werden kann, um die Konvertierung der Identifikationsdaten durchzuführen. Dies bietet den großen Vorteil, dass die Vorrichtung flexibel an verschiedenen Identifikationseinrichtungen (ID-Knoten) angepasst werden kann, beziehungsweise dort installiert werden kann.

Ausführungsbeispiele beziehen sich auch auf eine Vorrichtung 100, die in der Lage ist, eine Transformation eines Zeigers in eine Wahrscheinlichkeitsverteilung und von einer Wahrscheinlichkeitsverteilung zurück zum besten passenden Zeiger unter Nutzung einer XML-Definitionsdatei anzugeben. Die in XML spezifizierte Definitionsdatei (oder Konfigurationsdatei) ist vorteilhaft, da die Nutzung einer Auszeichnungssprache eine besonders geeignete Darstellung von hierarchisch strukturierten Daten und die Verknüpfung dieser Daten untereinander erlaubt. Darüber hinaus erlaubt die Nutzung von XML-basierten Tools eine einfache und fehlerfreie Editierung solcher strukturierter Daten. Die Konfigurationsdatei für die oben genannten Konfigurationselemente ist jedoch nicht an die Auszeichnungssprache XML gebunden. Statt XML könnte auch ein anderes universelles Format, beispielsweise JavaScript Object Notation (JSON) dafür verwendet werden. Ein Beispiel für eine XML Datei findet sich am Ende der Beschreibung.

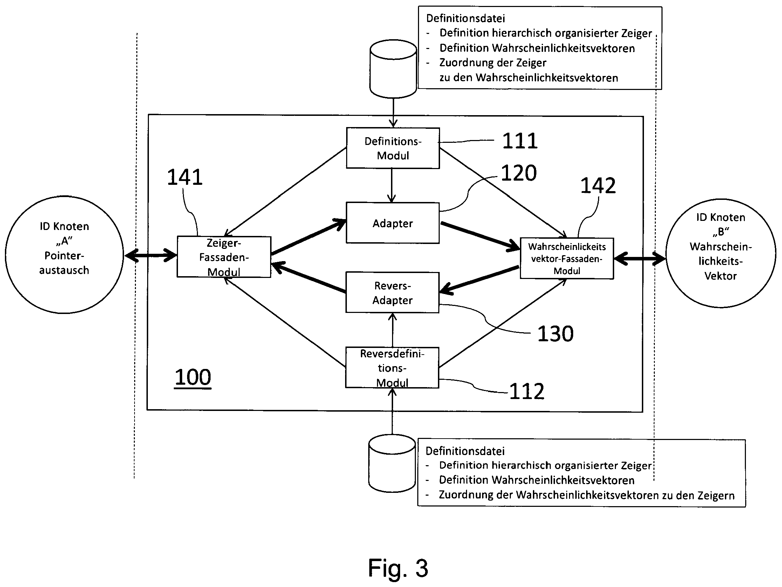

Die **Fig. 3** zeigt optionale Details der Vorrichtung 100 zum Umwandeln von Zeiger-basierten Zielidentifikationen gemäß weiterer Ausführungsbeispiele der vorliegenden Erfindung. Der Austausch der Daten/Informationen erfolgt wieder zwischen einem ID-Knoten A, der beispielhaft eine Zeiger-basierte Zielidentifikation nutzt, und einem ID-Knoten B, der beispielhaft eine Wahrscheinlichkeitsvektor-Identifikation nutzt. Sowohl der ID-Knoten A als auch der ID-Knoten B können beispielsweise Computerarchitekturen nutzen, die in der Fig. 3 nicht dargestellt sind (z.B. ein(e) spezifische Middleware Framework / Plattform wie CORBA oder OSGi). Es wird vorausgesetzt, dass irgendeine Art der Datenverbindung zwischen den zumindest zwei ID Knoten A, B besteht, wobei der Aufbau und die Art der Datenübertragung beliebig sein kann.

Die Vorrichtung 100 umfasst einen Adapter 120 (oder Adaptermodul), einen Umkehradapter 130 (oder Umkehradaptermodul) und ein erstes Definitionsmodul 111 und ein zweites Definitionsmodul 112 (die beide Teil des Definitionsmoduls 110 aus der Fig. 1 sind). Das erste Definitionsmodul 111 stellt die Definitionen für das Adaptermodul 120 bereit und das zweite Definitionsmodul 112 stellt die Definitionen für den Umkehradapter 130 bereit. Außerdem umfasst das Ausführungsbeispiel aus der Fig. 3 ein optionales erstes Zeiger-Fassaden-Modul 141 und ein zweites Fassadenmodul 142, das auch als Wahrscheinlichkeitsvektor-Fassaden-Modul bezeichnet werden kann.

Das erste Definitionsmodul 111 umfasst beispielsweise einen Speicher oder koppelt an eine externe Datenbank, in der eine Definitionsdatei gespeichert ist. Die Definitionsdatei umfasst beispielhaft zumindest eine der folgenden Informationen:

- Definition hierarchisch organisierter Zeiger,
- Definition von Wahrscheinlichkeitsvektoren,
- Zuordnung der Zeiger zu den Wahrscheinlichkeitsvektoren.

Das zweite Definitionsmodul 112 (oder Umkehrdefinitionsmodul) umfasst ebenfalls beispielhaft einen Speicher oder koppelt an eine externe Datenbank (z.B. die gleiche wie beim ersten Definitionsmoduls 111), wo wiederum eine Definitionsdatei abgespeichert ist, die beispielhaft zumindest eine der folgenden Informationen bereitstellt:

- Definition hierarchisch organisierter Zeiger,
- Definition von Wahrscheinlichkeitsvektoren,
- Zuordnung der Wahrscheinlichkeitsvektoren zu den Zeigern.

Bei den beiden Definitionsdateien kann es sich auch um ein und dieselbe Datei handeln bzw. sie können in einer gleichen Datenbank oder Speicher gespeichert sein, auf die beiden Definitionsmodule 111, 112 zugreifen können.

Beim Umwandeln der Identifikationsdaten vom ID-Knoten A in Identifikationsdaten für den ID-Knoten B wird zunächst die Information in das erste Zeiger-Fassaden-Modul 141 eingelesen und dort in ein internes Datenformat umgewandelt. Anschließend wird die Information an den Adapter 120 weitergeleitet, der unter Nutzung des ersten Definitionsmodul 111 die Zeiger-basierte Zielidentifikation in die Wahrscheinlichkeits-basierte Zielidentifikationsinformation umwandelt und diese an das Wahrscheinlichkeitsvektor-Fassaden-Modul 142 ausgibt. Das erste Definitionsmodul 111 kann auf die Definitionsdatei zugreifen, um zur Umwandlung erforderliche Informationen zu erhalten. Das Wahrscheinlichkeitsvektor-Fassaden-Modul 142 wandelt das interne Datenformat beispielhaft in einen Wahrscheinlichkeitsvektor um, der an dem ID-Knoten B ausgegeben wird.

Bei der Umkehrung wird ein Wahrscheinlichkeitsvektor von dem ID-Knoten B in das Wahrscheinlichkeitsvektor-Fassaden-Modul 142 eingelesen und von dort an den Umkehradaptermodul 130 weitergeleitet. Das Wahrscheinlichkeitsvektor-Fassaden-Modul 142 wandelt dabei die eingelesenen Daten in ein internes Datenformat um. In dem Umkehradaptermodul 130 erfolgt die Umwandlung der Wahrscheinlichkeits-basierten Ziel-Identifikationsinformation in die Zeiger-basierte Identifikation, wobei das zweite Definitionsmodul 112 genutzt wird, welches dazu auf die Definitionsdatei zur Umwandlung zugreifen kann. Das Umkehradaptermodul 130 gibt dann das Resultat an das Zeiger-Fassaden-Modul 141 aus, welches wieder eine Rückumwandlung des internen Datenformates in ein Datenformat umwandelt, welches der ID-Knoten A weiterverwenden kann.

Das Zeiger-Fassaden-Modul 141 und ebenso das Wahrscheinlichkeitsvektor-Fassaden-Modul 142 sind optional, um zu erreichen, dass die Vorrichtung für verschiedene ID-Knoten genutzt werden kann und dabei nicht ihr intern genutztes Format zu ändern brauchen. Wenn z.B. eine technische (physikalische) Verbindung zu einem sendenden ID Knoten A besteht, von dem Identifizierungs- und Klassifizierungs-Informationen im Datenformat ASTERIX, Link-16 bzw. Link-22 oder ADatP-3 bzw. NITS empfangen werden, ist es vorteilhaft, wenn nicht für jedes Format eine separate Vorrichtung genutzt werden muss, sondern die unterschiedlichen Formate in ein generelles Konverter-internes Datenformat umgewandelt werden. Häufig wäre ansonsten auch ein Wechsel der sog. Middleware/Framework Interprozesskommunikation notwendig.

Das Zeiger-Fassaden-Modul 141 führt daher die erste Stufe der Konvertierung durch, sodass als bearbeitbare Information Datenobjekte in geeigneter Weise vorliegen und externe Datenformate und Kommunikationsprotokolle nicht in der eigentlichen Konvertierungs-Verarbeitung weiter berücksichtigt werden müssen. Das interne Adaptermodule 120 und das Umkehradaptermodul 130 sind also von externen Datenformate und Kommunikationsprotokollen gekapselt. Liegen die empfangenen Informationen schon in geeigneter Form vor, so kann diese Kapselung entfallen. Gleiches trifft zu für den umgekehrten Datenfluss, bei dem häufig ein weiteres Fassadenmodul sinnvoll ist, das als Wahrscheinlichkeitsvektor-Fassaden-Modul 142 bezeichnet wird und prinzipiell derselben Aufgabe dient.

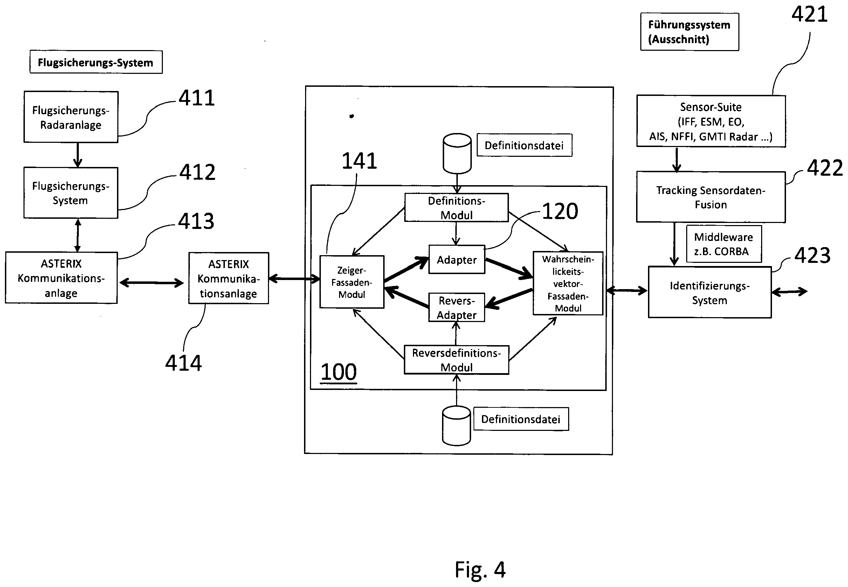

In **Fig. 4** ist eine Anwendung der Vorrichtung 100 dargestellt, wobei im gezeigten Beispiel Identifizierungsinformationen von einem Flugsicherungssystem als Zeigerinformation im ASTERIX Format via TCP/IP zum Führungssystem übertragen werden und die Vorrichtung 100 diese Information in die entsprechenden Wahrscheinlichkeits-Vektoren konvertiert. Bei dem gezeigten Ausführungsbeispiel ist die Vorrichtung 100 in der gleichen Weise ausgebildet ist, wie es in der Fig. 3 gezeigt ist.

Bei der gezeigten Anwendung ist der ID-Knoten A ein Flugsicherungssystem mit einer Flugsicherungs-Radaranlage 411, einem Flugsicherungssystem 412, einer Kommunikationsanlage 413 und einer weiteren Kommunikationsanlage 414. Beide Kommunikationsanlagen 413, 414 können räumlich voneinander getrennt sein und nutzen beispielhaft das ASTERIX-Format zu Datenübertragung untereinander und zur Vorrichtung 100. Zum Beispiel kann die Zeigerinformation als ASTERIX-Meldung wie folgt kodiert werden:

- Evaluierte Antwort auf IFF/SSR Abfrage in Mode 1, 2, 3/A ...
- Ziel Nr. XYZ folgt zivilem Flugplan Nr. ABCD

wobei XYZ bzw. ABCD beliebige Nummern sein können.

Der ID-Knoten B ist beispielsweise das Führungssystem mit einem Sensorsystem 421, einer Sensordatenfusionseinheit 422 und einem Identifikationssystem 423. Die Sensoreinheit 421 kann eine Vielzahl von Sensoren umfassen, die ihre Sensordaten an die Sensorfusionseinheit 422 weiterleiten, wo beispielhaft die Sensordaten miteinander fusioniert werden und bestimmten Objekten oder Tracking-Pfaden zugeordnet werden. Die Kommunikation zwischen der Sensordatenfusionseinheit 422 und dem Identifizierungssystem 423 kann unter Nutzung einer beliebigen Middleware (z.B. CORBA) erfolgen. Das Identifizierungssystem 423 kann die Identifizierung der erfassten Objekte durchführen und die Resultate als Wahrscheinlichkeitsvektoren ausgeben. Dazu kann es optional noch weitere Informationen aus anderen Quellen nutzen, wie es durch den Doppelpfeil nach rechts angedeutet ist.

Die Vorrichtung 100 wandelt die Wahrscheinlichkeitsvektoren aus dem Identifizierungssystem 423 in eine Zeigerinformation für die weitere Kommunikationsanlage 414 um. Für die Übertragung können die Formate TCP/IP oder ASTERIX genutzt werden. Die Zeigerinformation kann dann an die Kommunikationsanlage 413 und anschließend an das Flugsicherungssystem 412 weitergeleitet werden.

Somit werden in diesem Ausführungsbeispiel aus Daten der Fluchsicherungs-Radaranlage im Flugsicherungssystem Identifizierungs-Quelleninformationen gewonnen und als Zeigerinformation in geeignete ASTERIX Meldungen in einem TCP/IP Datenstrom von der ASTERIX Kommunikationsanlage 413 übertragen.

Dafür ist eine spezielle militärisch genutzte ASTERIX Kategorie vorgesehen. Die empfangende ASTERIX Kommunikationsanlage 414 im Führungssystem sendet diesen TCP/IP Datenstrom an die Vorrichtung 100, wobei das Zeiger-Fassadenmodul 141 aus dem Datenstrom die ASTERIX Meldung extrahiert und die Zeigerinformation in ein internen Datenformat an das Adaptermodul 120 übergibt. Das Adaptermodul 120 konvertiert diese Zeigerinformation gemäß der eingelesenen Konfiguration in eine geeignete Wahrscheinlichkeits-Vektor Information, welche für die weitere Verarbeitung im Identifizierungs-System 423 geeignet ist. Damit kann nun die Identifizierungsinformation des Flugsicherungssystems für die Identifizierung im Führungssystem genutzt, weiterverabeitet und fusioniert werden. Damit wurde das Führungssystem um einen "externen Sensor" erweitert.

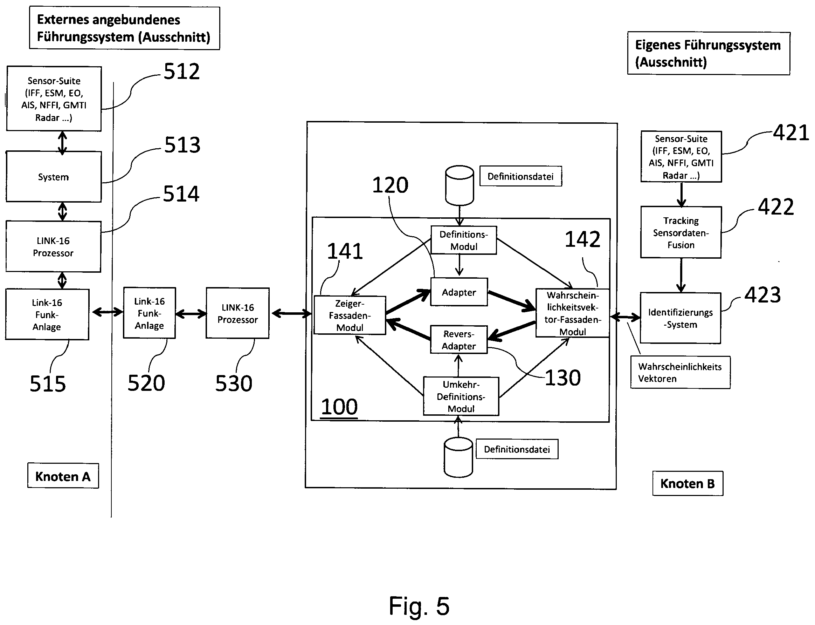

Die Fig. 5 zeigt eine Anwendung der Vorrichtung 100, bei der die Ziel-Identifizierungsinformationen als Zeigerinformation im Link-16 Format von einem externen angebundenen Führungssystem (Knoten A) zu einem zweiten Führungssystem (eigenes Führungssystem; Knoten B) übertragen werden und umgekehrt. Die vorgeschaltete Vorrichtung 100 konvertiert diese Zeiger-Information in die entsprechenden Wahrscheinlichkeits-Vektoren und umgekehrt.

Das eigene Führungssystem (Knoten B) aus der Fig. 5 kann in einer gleichen Weise aufgebaut sein wie das Führungssystem in der Fig. 4. Das externe angebundene Führungssystem (Knoten A) kann wiederum eine Sensoreinheit 512, ein System 513, einen spezifischen Link-16 Prozessor 514 und eine Link-16 Funkanlage 515 umfassen. Die Sensoreinheit 512 erfasst wieder Sensordaten von verschiedenen Sensoren und übermittelt diese an das System 513. Dort kann eine Verarbeitung der Sensordaten erfolgen. Über den Link-16 Prozessor 514 werden die Resultate unter Nutzung der Link-16 Funkanlage 515 an eine weitere Link-16 Funkanlage 520 in dem spezifischen Link-16 Format übermittelt. Beide Link-16 Funkanlagen 515, 520 können räumlich getrennt sein und die Datenübertragung kann drahtlos über Funk erfolgen. Zum Beispiel kann ein Inhalt mit einer Link-16 Meldung wie folgt kodiert werden:

- Ziel Nr. XYZ ist von feindlichen genutztem Flughafen QWDFG gestartet
- Ziel Nr. XYZ hat eigenen Luftraum verletzt

wobei XYZ eine beliebige Nummer sein kann.

Die von dem Knoten A über die weitere Link-16 Funkanlage 520 weitergegebenen Daten werden als empfangene Daten in einem Link-16 Prozessor 530 verarbeitet und als Link-16 Meldung mit Zeigerinformation ausgeben. Diese Zeigerinformation wird dann in die Vorrichtung 100 der Zeigerinformation eingegeben.

Die beschriebenen Beispiele zeigen, dass Ausführungsbeispielene beliebige Konvertierungen von Zeiger-basierten Identifizierungsdaten in eine Wahrscheinlichkeitsverteilung und umgekehrt von einer Wahrscheinlichkeitsverteilungs-basierten Identifikation in Zeiger-basierte Identifizierungsdaten ermöglichen. Im Folgenden sollen besonders vorteilhafte Aspekte dargestellt werden.

In dem Ausführungsbeispiel der Fig. 4 wurde ein "Externes Führungssystem" (Knoten A) mit dem "eigenen" Führungssystem (Knoten B) zusammengeschlossen, um einen Identifizierungsverbund zu realisieren. Damit kann das Ziel erreicht werden, dass beide Führungssysteme ihre Identifizierungsdaten austauschen und somit zu einem verbesserten, umfangreicheren, verlässlicherem und durch Dislozierung der Systeme zu einem flächenmäßig größerem Lagebild kommen.

In dem Ausführungsbeispiel der Fig. 5 werden vom externen Führungssystem (Knoten A) anhand dessen Sensoren 512 Identifizierungs-Quelleninformationen gewonnen und als Zeigerinformation über eine Link-16 Funk-Kommunikation übertragen. Die empfangende Link-16 Anlage 520 dekryptiert und decodiert diese Meldungen und überträgt die Link-16 Meldung mit den Zeigerinformationen an die Vorrichtung 100, wobei das Zeiger Fassadenmodul 141 aus der Link-16 Meldung die Zeigerinformation extrahiert und die Zeigerinformation in einem internen Datenformat an das Adaptermodul 120 übergibt. Das Adaptermodul 120 konvertiert die Zeigerinformationen gemäß der eingelesenen Konfiguration des Adaptermoduls 120 in eine geeignete Wahrscheinlichkeits-Vektor Informationen, welche für die weitere Verarbeitung im Identifizierungs-System 423 geeignet sind.

Damit kann nun die Identifizierungsinformation des Externen Führungssystems (Knoten A) für die (eigene) Identifizierung im Führungssystem (Knoten B) genutzt, weiterverabeitet und fusioniert werden. Damit wurde das Führungssystem um zusätzliche "externe Sensoren" erweitert.

Ebenso werden in dem Ausführungsbeispiel der Fig. 5 die eigenen, von den eigenen Sensoren gewonnenen Identifizierungs-Quelleninformationen, welche im Wahrscheinlichkeitsvektor-Format vorliegen, über das Wahrscheinlichkeitsvektor-Fassaden-Modul 142 an den Umkehradapter 130 übertragen und in das Zeigerformat konvertiert. Die ID-Informationen werden im Zeiger-Fassaden-Modul 141 in enstprechende Link-16 Meldungen gepackt und über den Link-16 Prozessor 530 wieder verschlüsselt und per Link-16 Funk-Anlage 520 dem Externen Führungssystem (Knoten A) zur Verarbeitung übermittelt. Es wird also der bi-direktionale Datenübermittlung genutzt.

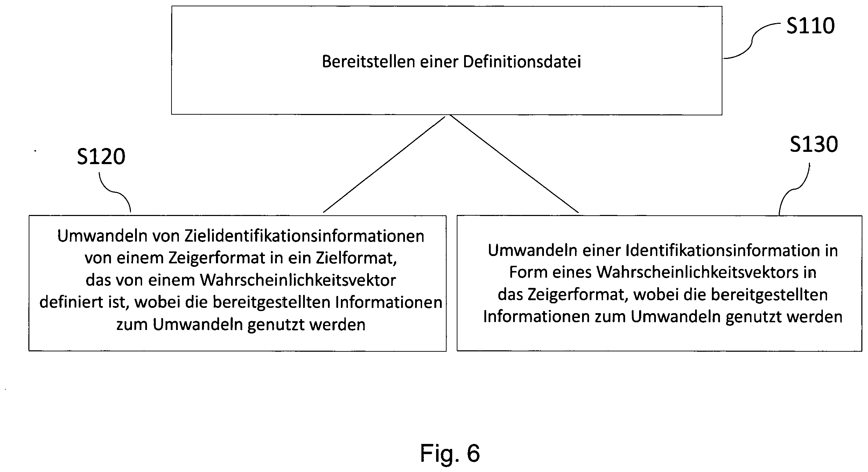

**Fig. 6** zeigt ein Flussdiagramm für ein Verfahren zur Konvertierung von Ziel-Identifikationsdaten im Zeigerformat gemäß einem Ausführungsbeispiel der vorliegenden Erfindung. Das Verfahren umfasst ein Bereitstellen S110 einer Definitionsdatei mit zumindest einer der folgenden Informationen:

- Definition der hierarchisch organisierten Referenzen,
- Format der hierarchisch organisierten Referenzen,
- Definition von einzelnen Wahrscheinlichkeitsvektoren,
- Format von einzelnen Wahrscheinlichkeitsvektoren,
- Zuordnung der hierarchisch organisierten Referenzen zu den Wahrscheinlichkeitsvektoren,
- Zuordnung der Wahrscheinlichkeitsvektoren zu den hierarchisch organisierten Referenzen.

Außerdem umfasst das Verfahren ein Umwandeln S120 von Ziel-Identifikationsdaten von einem Zeigerformat in ein Wahrscheinlichkeitsvektorformat, das von einem oder mehreren Wahrscheinlichkeitsvektoren definiert ist, wobei die bereitgestellten Informationen zum Konvertieren genutzt werden. Bei einer Konvertierung in die umgekehrte Richtung umfasst das Verfahren stattdessen ein Umwandeln S130 von Ziel-Identifikationsdaten in Form eines Wahrscheinlichkeitsvektors in das Zeigerformat, wobei die bereitgestellten Informationen zum Konvertieren genutzt werden.

Es versteht sich, dass alle zuvor beschriebenen Funktionen der Vorrichtung 100 ebenfalls als optionale Verfahrensschritte umgesetzt sein können.

Das Verfahren kann ebenfalls Computer-implementiert sein, d.h. es kann durch Anweisungen umgesetzt sein, die auf einem Speichermedium gespeichert sind und in der Lage sind, die Schritte des Verfahrens auszuführen, wenn es auf einem Prozessor läuft. Die Anweisungen umfassen typischerweise eine oder mehrere Anweisungen, die auf unterschiedliche Art auf unterschiedlichen Medien in oder peripher zu einem Computersystem (mit einem Prozessor) gespeichert sein können, die, wenn sie gelesen und durch das Computersystem ausgeführt werden, die Steuereinheit dazu veranlassen, Funktionen, Funktionalitäten und Operationen auszuführen, die zum Ausführen eines Verfahrens gemäß der vorliegenden Erfindung notwendig sind.

Im Folgenden wird beispielhaft die prinzipielle Struktur einer Definitionsdatei mittels XML am Beispiel einer AIS- (Automatic Identification System) Identifizierungsinformation gezeigt. Diese XML-Datei kann durch das Computersystem ausgeführt werden.

Dieses Beispiel ist nicht vollständig und erhebt keinen Anspruch auf sinnvolle Werte, sondern soll nur die prinzipielle Struktur und Umsetzbarkeit der Konfiguration des Verfahrens gemäß der Erfindung aufzeigen.

Im Abschnitt <LV_source name="AIS"> wird die Daten-Struktur für die Elemente der Wahrscheinlichkeitsverteilung definiert:

Hier in diesem Beispiel werden die Typdefinitionen/Datenstrukturen für eine sog. Deklaration für den Quelltyp "AIS" definiert, welche aus den Quellen-spezifischen diskriminierten Objektklassen

- Fitted and operating, sending data x
- Fitted and operating, sending data different from x
- Fitted and not operating or not fitted

und den eigentlichen Deklarationen für

- AIS data received
- AIS data not received

besteht.

Die Anzahl der Quellen-spezifischen diskriminierten Objektklassen und der Deklarationen definieren hier eine 2*3 Matrix von Werten, bei der jede Zeile, genau eine Deklaration abbildet; in diesem Beispiel ein Tripel von Werten, das die Wahrscheinlichkeitsverteilung dieser Deklaration darstellt. So gibt es in diesem Beispiel für die Deklaration "AIS data received" für jeweils "Fitted and operating, sending data x", "Fitted and operating, sending data different from x" und "Fitted and not operating or not fitted" einen Wahrscheinlichkeitswert.

Im folgenden Abschnitt wird dann noch eine Unterscheidung zwischen AIS Meldungen ohne Verfälschung ("non Spoofing") und für AIS Meldungen mit absichtlicher Verfälschung der Daten ("Spoofer") beispielhaft aufgezeigt.

Im Abschnitt <pointer name="AIS"> wird die Daten-Struktur für die dazu entsprechenden Zeiger-Elemente definiert, ebenso werden hier (beispielhaft) die dazugehörigen codierten Werte der Deklarationen festgelegt.

Im Abschnitt <Conversion_Pointer_to_Decl> wird die Konvertierung der Zeiger-Elemente in die Wahrscheinlichkeitsverteilung festgelegt:

Beispielhaft wird durch den Abschnitt

```
<Conversion_Pointer_to_Decl>
   <Conv_Pointer_to_Decl Value= "AIS" />
      <p_subtype name="AIS non spoofing" encoded_as="001001">
         <declaration name="AIS data received" decl_code="001">

      <confidence value="01">
         <Prob_source_spec_class name="Fitted and operating, sending data x"
value="0.8" />
         <Prob_source_spec_class name="Fitted and operating, sending data
different from x" value="0.1" />
         <Prob_source_spec_class name="Fitted and not operating or not fitted"
value="0.1" />
      </confidence >
   </declaration>
```

die Konvertierungsvorschrift für eine Deklaration "AIS data received" für den Fall "AIS non spoofing" (codiert als 001001 001 01) festgelegt als eine beispielhafte Wahrscheinlichkeitsverteilung:

p (AIS data received | Fitted and operating, sending data x) = 0.8,
p (AIS data received | Fitted and operating, sending data different from x) = 0.1,
p (AIS data received | Fitted and not operating or not fitted) = 0.1
oder in Kurzschreibweise als Tripel : [0.8, 0.1, 0.1]

Die Schreibweise

"p (AIS data received | Fitted and operating, sending data x)=0.8"

bedeutet dabei, dass die Wahrscheinlichkeit für die Deklaration "*AIS data* received" unter der Bedingung "*Fitted and operating, sending data x*" 0.8 ist. Prinzipiell kann der letzte Eintrag für das n-Tupel (hier für p (AIS data received | Fitted and not operating or not fitted)) entfallen, da dies bei normierten Werten immer der Restbetrag zur Summe 1.0 ist. Ob die vollständige Wahrscheinlichkeitsverteilung abgelegt oder der letzte Wert im Adapter berechnet wird, hängt von der Ausführung des Adapters ab.

Im Abschnitt <Conversion_Decl_to_Pointer Value wird die (reverse oder Umkehr) Konvertierung von verschiedenen Wahrscheinlichkeitsverteilungen in adäquate Zeiger-Elemente festgelegt.

Beispielhaft wird durch den Abschnitt

*<Conversion_Decl_to_Pointer>*

  *<Conv_Decl_to_Pointer Type="AIS" >*

    *<p_subtype name="AIS non spoofing" encoded_as="001001">*

      *<declaration name="AIS data received" decl_code="001" >*

        *<Conv_source_spec SDOC_name1="Fitted and operating, sending data x"*

*SDOC_value1="0.8" SDOC_name2="Fitted and operating, sending data different*

*from x" SDOC_value2="0.1" confidence_value="01"/>*

die Wahrscheinlichkeitsverteilung der Deklaration "AIS data received" für den Fall "AIS non spoofing"

p (AIS data received | Fitted and operating, sending data x) = 0.8,
p (AIS data received | Fitted and operating, sending data different from x) = 0.1,
p (AIS data received | Fitted and not operating or not fitted) = 0.1

codiert in den Zeiger 001001 001 01.

Aus Gründen der Redundanz (und durch die Normierung der Wahrscheinlichkeiten) kann der letzte Werte in der Konvertierungsvorschrift entfallen, da diese Wahrscheinlichkeit der fehlende Wert zur Summe 1.0 ist.

Die Rück-Konvertierung ist immer eine Suche innerhalb der definierten Werte und per Definition gibt es daher nicht (immer) den exakten passenden Wert (sonst müssten beliebig viele Werte hinterlegt werden). In diesen Fällen wird der beste passende und plausibelste Wert gewählt. Eine hinreichend granulare Auswahlmöglichkeit wird vorrausgesetzt.

Beispiel für die Definitionsdatei mittels XML:

```
<?xml version="1.0" encoding="UTF-8"?>
<Adapter>
<LV_source name="AIS">
<subtype name="AIS non spoofing">
 <source_spec_class name="Fitted and operating, sending data x "/>
 <source_spec_class name="Fitted and operating, sending data different from x
 "/>
 <source_spec_class name="Fitted and not operating or not fitted "/>
 <declaration name="AIS data received"/>
 <declaration name="AIS data not received "/>
</subtype>
<subtype name="AIS spoofer">
 <source_spec_class name="Fitted and operating, sending data x "/>
```

```
  <source_spec_class name="Fitted and operating, sending data different from x
  "/>
  <source_spec_class name="Fitted and not operating or not fitted "/>
  <declaration name="AIS data received"/>
  <declaration name="AIS data not received"/>
</subtype>
</LV_source>
<pointer name="AIS">
<p_subtype name="AIS non spoofing" encoded_as="001001">
  <declaration name="AIS data received" decl_code="001"/>
  <declaration name="AIS data not received" decl_code="002"/>
</p_subtype>
<p_subtype name="AIS spoofer" encoded_as="001002">
  <declaration name="AIS data received" decl_code="001"/>
  <declaration name="AIS data not received" decl_code="002"/>
</p_subtype>
</pointer>
< Conversion_Pointer_to_Ded >
<Conv_Pointer_to_Decl Value= "AIS" />
 <p_subtype name="AIS non spoofing" encoded_as="001001">
  <declaration name="AIS data received" decl_code="001">
   <confidence value="01">
    <Prob_source_spec_class name="Fitted and operating, sending data x"
    value="0.8"/>
    <Prob_source_spec_class name="Fitted and operating, sending data
    different from x" value="0.1"/>
    <Prob_source_spec_class name="Fitted and not operating or not fitted"
    value="0.1"/>
   </confidence>
  </declaration>
  <declaration name="AIS data not received" decl_code="002">
   <confidence value="02">
    <Prob_source_spec_class name="Fitted and operating, sending data x"
    value="0.2"/>
    <Prob_source_spec_class name="Fitted and operating, sending data
    different from x" value="0.7"/>
    <Prob_source_spec_class name="Fitted and not operating or not fitted"
    value="0.1"/>
   </confidence>
  </declaration>
 </p_subtype>
 <p_subtype name="AIS spoofer" encoded_as="001002">
  <declaration name="AIS data received" decl_code="001">
   <confidence value="01">
    <Prob_source_spec_class name="Fitted and operating, sending data x"
    value="0.5"/>
    <Prob_source_spec_class name="Fitted and operating, sending data
    different from x" value="0.4"/>
    <Prob_source_spec_class name="Fitted and not operating or not fitted"
    value="0.1"/>
   </confidence>
  </declaration>
  <declaration name="AIS data not received" decl_code="002">
   <confidence value="02">
    <Prob_source_spec_class name="Fitted and operating, sending data x"
    value="0.2"/>
    <Prob_source_spec_class name="Fitted and operating, sending data
    different from x" value="0.6"/>
    <Prob_source_spec_class name="Fitted and not operating or not fitted"
    value="0.2" />
   </confidence>
  </confidence /declaration>
 </p_subtype>
```

```
</Conversion_Pointer_to_Decl>
<Conversion_Decl_to_Pointer>
<Conv_Decl_to_Pointer Type="AIS">
 <p_subtype name="AIS non spoofing" encoded_as="001001">
  <declaration name="AIS data received" decl_code="001">
   <Conv_source_spec SDOC_name1="Fitted and operating, sending data x"
   SDOC_value1="0.8" SDOC_name2="Fitted and operating, sending data different
   from x" SDOC_value2="0.1" confidence_value="01"/>
   <Conv_source_spec SDOC_name1="Fitted and operating, sending data x"
   SDOC_value1="0.7" SDOC_name2="Fitted and operating, sending data different
   from x" SDOC_value2="0.2" confidence_value="02"/>
   <Conv_source_spec SDOC_name1="Fitted and operating, sending data x"
   SDOC_value1="0.6" SDOC_name2="Fitted and operating, sending data different
   from x" SDOC_value2="0.3" confidence_value="03"/>
   <Conv_source_spec SDOC_name1="Fitted and operating, sending data x"
   SDOC_value1="0.5" SDOC_name2="Fitted and operating, sending data different
   from x" SDOC_value2="0.4" confidence_value="04"/>
   <Conv_source_spec SDOC_name1="Fitted and operating, sending data x"
   SDOC_value1="0.4" SDOC_name2="Fitted and operating, sending data different
   from x" SDOC_value2="0.5" confidence_value="05"/>
   <Conv_source_spec SDOC_name1="Fitted and operating, sending data x"
   SDOC_value1="0.3" SDOC_name2="Fitted and operating, sending data different
   from x" SDOC_value2="0.6" confidence_value="06"/>
   <Conv_source_spec SDOC_name1="Fitted and operating, sending data x"
   SDOC_value1="0.2" SDOC_name2="Fitted and operating, sending data different
   from x" SDOC_value2="0.7" confidence_value="07"/>
   <Conv_source_spec SDOC_name1="Fitted and operating, sending data x"
   SDOC_value1="0.1" SDOC_name2="Fitted and operating, sending data different
   from x" SDOC_value2="0.8" confidence_value="08"/>
  </declaration>
  <declaration name="AIS data not received" decl_code="002" >
   <Conv_source_spec SDOC_name1="Fitted and operating, sending data x"
   SDOC_value1="0.1" SDOC_name2="Fitted and operating, sending data different
   from x" SDOC_value2="0.8" confidence_value="01"/>
   <Conv_source_spec SDOC_name1="Fitted and operating, sending data x"
   SDOC_value1="0.2" SDOC_name2="Fitted and operating, sending data different
   from x" SDOC_value2="0.7" confidence_value="02"/>
   <Conv_source_spec SDOC_name1="Fitted and operating, sending data x"
   SDOC_value1="0.3" SDOC_name2="Fitted and operating, sending data different
   from x" SDOC_value2="0.6" confidence_value="03"/>
   <Conv_source_spec SDOC_name1="Fitted and operating, sending data x"
   SDOC_value1="0.4" SDOC_name2="Fitted and operating, sending data different
   from x" SDOC_value2="0.5" confidence_value="04"/>
   <Conv_source_spec SDOC_name1="Fitted and operating, sending data x"
   SDOC_value1="0.5" SDOC_name2="Fitted and operating, sending data different
   from x" SDOC_value2="0.4" confidence_value="05"/>
   <Conv_source_spec SDOC_name1="Fitted and operating, sending data x"
   SDOC_value1="0.6" SDOC_name2="Fitted and operating, sending data different
   from x" SDOC_value2="0.3" confidence_value="06"/>
   <Conv_source_spec SDOC_name1="Fitted and operating, sending data x"
   SDOC_value1="0.7" SDOC_name2="Fitted and operating, sending data different
   from x" SDOC_value2="0.2" confidence_value="07"/>
   <Conv_source_spec SDOC_name1="Fitted and operating, sending data x"
   SDOC_value1="0.8" SDOC_name2="Fitted and operating, sending data different
   from x" SDOC_value2="0.1" confidence_value="08"/>
  </confidence/declaration>
 </p_subtype>
 <p_subtype name="AIS spoofer" encoded_as="001002">
  <declaration name="AIS data received" decl_code="001">
   <Conv_source_spec SDOC_name1="Fitted and operating, sending data x"
   SDOC_value1="0.1" SDOC_name2="Fitted and operating, sending data different
   from x" SDOC_value2="0.8" confidence_value="01"/>
   <Conv_source_spec SDOC_name1="Fitted and operating, sending data x"
```

```
      SDOC_value1="0.2" SDOC_name2="Fitted and operating, sending data different
      from x" SDOC_value2="0.7" confidence_value="02"/>
      <Conv_source_spec SDOC_name1="Fitted and operating, sending data x"
      SDOC_value1="0.3" SDOC_name2="Fitted and operating, sending data different
      from x" SDOC_value2="0.6" confidence_value="03"/>
      <Conv_source_spec SDOC_name1="Fitted and operating, sending data x"
      SDOC_value1="0.4" SDOC_name2="Fitted and operating, sending data different
      from x" SDOC_value2="0.5" confidence_value="04"/>
      <Conv_source_spec SDOC_name1="Fitted and operating, sending data x"
      SDOC_value1="0.5" SDOC_name2="Fitted and operating, sending data different
      from x" SDOC_value2="0.4" confidence_value="05"/>
      <Conv_source_spec SDOC_name1="Fitted and operating, sending data x"
      SDOC_value1="0.6" SDOC_name2="Fitted and operating, sending data different
      from x" SDOC_value2="0.3" confidence_value="06"/>
      <Conv_source_spec SDOC_name1="Fitted and operating, sending data x"
      SDOC_value1="0.7" SDOC_name2="Fitted and operating, sending data different
      from x" SDOC_value2="0.2" confidence_value="07"/>
      <Conv_source_spec SDOC_name1="Fitted and operating, sending data x"
      SDOC_value1="0.8" SDOC_name2="Fitted and operating, sending data different
      from x" SDOC_value2="0.1" confidence_value="08"/>
     </declaration>
     <declaration name="AIS data not received" decl_code="002">
      <Conv_source_spec SDOC_name1="Fitted and operating, sending data x"
      SDOC_value1="0.1" SDOC_name2="Fitted and operating, sending data different
      from x" SDOC_value2="0.8" confidence_value="01"/>
      <Conv_source_spec SDOC_name1="Fitted and operating, sending data x"
      SDOC_value1="0.2" SDOC_name2="Fitted and operating, sending data different
      from x" SDOC_value2="0.7" confidence_value="02"/>
      <Conv_source_spec SDOC_name1="Fitted and operating, sending data x"
      SDOC_value1="0.3" SDOC_name2="Fitted and operating, sending data different
      from x" SDOC_value2="0.6" confidence_value="03"/>
      <Conv_source_spec SDOC_name1="Fitted and operating, sending data x"
      SDOC_value1="0.4" SDOC_name2="Fitted and operating, sending data different
      from x" SDOC_vame2="0.5" confidence_value="04"/>
      <Conv_source_spec SDOC_name1="Fitted and operating, sending data x"
      SDOC_value1="0.5" SDOC_name2="Fitted and operating, sending data different
      from x" SDOC_value2="0.4" confidence_value="05"/>
      <Conv_source_spec SDOC_name1="Fitted and operating, sending data x"
      SDOC_value1="0.6" SDOC_name2="Fitted and operating, sending data different
      from x" SDOC_value2="0.3" confidence_value="06"/>
      <Conv_source_spec SDOC_name1="Fitted and operating, sending data x"
      SDOC_value1="0.7" SDOC_name2="Fitted and operating, sending data different
      from x" SDOC_value2="0.2" confidence_value="07"/>
      <Conv_source_spec SDOC_name1="Fitted and operating, sending data x"
      SDOC_value1="0.8" SDOC_name2="Fitted and operating, sending data different
      from x" SDOC_value2="0.1" confidence_value="o8"/>
     </declaration>
    </p_subtype>
   </Conv_Decl_to_Pointer>
   </Conversion-Decl-to-Pointer>
   < /Adapter >
```

Die in der Beschreibung, den Ansprüchen und den Figuren offenbarten Merkmale der Erfindung können sowohl einzeln als auch in beliebiger Kombination für die Verwirklichung der Erfindung wesentlich sein.

Bezugszeichenliste

| | |
|---|---|
| 100 | Vorrichtung |
| 110, 111, 112 | Definitionsmodul(e) |
| 120 | Adaptermodul |

| 130 | Umkehr-Adaptermodul |
|---|---|
| 141, 142 | Fassaden-Module |
| 411 | Radaranlage |
| 412 | Flugsicherungssystem |
| 413, 414 | Kommunikationsanlagen |
| 421, 512, 610 | Sensoreinheit |
| 422 | Sensordaten-Fusionseinheit |
| 432, 624 | Identifizierungssystem |
| 513, 620 | System |
| 514, 530 | Link-16 Prozessoren |
| 515, 520 | Link-16 Funkanlagen |
| 630 | Ausgabeeinheit |
| 640 | Netzwerkeinheit |

**Patentansprüche**

1. Vorrichtung (100) zur Konvertierung von Zielobjekt-Identifikationsdaten in einem Zeigerformat, das durch Zeiger auf vorab definierte und gespeicherte hierarchisch organisierte Referenzen auf Sensor- oder Quellen-spezifischen Wahrscheinlichkeitsverteilungen definiert ist, die Vorrichtung (100) umfasst die folgenden Merkmale:

   ein Definitionsmodul (110), in dem zumindest eine der folgenden Konfigurationsinformationen verfügbar ist:

   - Definition der hierarchisch organisierten Referenzen,
   - Format der hierarchisch organisierten Referenzen,
   - Definition von einzelnen Wahrscheinlichkeitsvektoren,
   - Format von einzelnen Wahrscheinlichkeitsvektoren,
   - Zuordnung der hierarchisch organisierten Referenzen zu den Wahrscheinlichkeitsvektoren,
   - Zuordnung der Wahrscheinlichkeitsvektoren zu den hierarchisch organisierten Referenzen;

   ein Adaptermodul (120), das ausgebildet ist, um unter Nutzung des Definitionsmoduls (110) die Zielobjekt-Identifikationsdaten von einem Zeigerformat in ein Zielformat zu konvertieren, wobei das Zielformat ein Wahrscheinlichkeitsvektorformat ist, das durch zumindest einen Wahrscheinlichkeitsvektor definiert ist; und
   ein Umkehr-Adaptermodul (130), das ausgebildet ist, um unter Nutzung des Definitionsmoduls (110) die Zielobjekt-Identifikationsdaten in Form eines Wahrscheinlichkeitsvektors in ein Zeigerformat zu konvertieren.

2. Vorrichtung (100) nach Anspruch 1, wobei das Definitionsmodul (110) ausgebildet ist, um interne Datenobjekte, Datenstrukturen und interne Verknüpfungen des Adaptermoduls und/oder des Umkehr-Adaptermoduls anhand einer Konvertierungsvorschrift abzuleiten und in einem für das Adaptermodul oder für das Umkehr-Adaptermodul (130) bearbeitbare Form umzuwandeln.

3. Vorrichtung (100) nach Anspruch 1 oder Anspruch 2, wobei das Zeigerformat ein Satz von Zeigern zu verschiedenen Wahrscheinlichkeitsvektoren definiert und das Umkehr-Adaptermodul (130) weiter ausgebildet ist, um bei der Konvertierung in das Zeigerformat eine Näherung durchzuführen, bei der jener Zeiger aus dem Satz von Zeigern gewählt wird, der dem Wahrscheinlichkeitsvektor am nächsten kommt.

4. Vorrichtung (100) nach einem der vorhergehenden Ansprüche, wobei das Definitionsmodul (110) ein erstes Definitionsmodul (111) und ein zweites Definitionsmodul (112) umfasst, wobei das erste Definitionsmodul (111) Definitionen für das Adaptermodul (120) bereitstellt und das zweite Definitionsmodul (112) Definitionen für den Umkehradapter (130) bereitstellt.

5. Vorrichtung (100) nach einem der vorhergehenden Ansprüche, die weiter einen Speicher umfasst, um die Konfigurationsinformationen für das Definitionsmodul (110) zu speichern, insbesondere in einem XML-Format.

6. Vorrichtung (100) nach einem der vorhergehenden Ansprüche, die weiter eine Netzwerkschnittstelle umfasst, um auf eine externe Datenbank, die die Konfigurationsinformationen bereitstellt, zu zugreifen, und wobei das Definitionsmodul (110) ausgebildet ist, um die Konfigurationsinformationen von der externen Datenbank zu laden.

**7.** Vorrichtung (100) nach einem der vorhergehenden Ansprüche, wobei das Adaptermodul (120) und das Umkehr-Adaptermodul (130) ausgebildet sind, ein internes Datenformat zu nutzen und die Vorrichtung (100) weiter Folgendes umfasst:

ein erstes Fassaden-Modul (141), das ausgebildet ist, um eine physikalische Schnittstellenanbindung an eine externe Datenschnittstelle und eine Konvertierung zwischen empfangenen Daten im Zeigerformat und Daten in dem intern genutzten Datenformat bereitzustellen,
ein zweites Fassaden-Modul (142), das ausgebildet ist, um die physikalische Schnittstellenanbindung an eine weitere Datenschnittstelle und eine Konvertierung zwischen empfangenen Daten im Wahrscheinlichkeitsvektorformat und Daten in dem intern genutzten Datenformat bereitzustellen.

**8.** Ziel-Identifizierungseinrichtung (ID-Knoten) mit einer Schnittstelle zum Empfangen oder Übermitteln von Informationen an externe ID-Knoten, wobei die Schnittstelle eine Vorrichtung (100) nach einem der Ansprüche 1 bis 7 aufweist.

**9.** System mit:

einer ersten Identifizierungseinrichtung (ID-Knoten A); und
einer zweiten Identifizierungseinrichtung (ID-Knoten B),
wobei die erste Identifizierungseinrichtung (ID-Knoten A) oder die zweite Identifizierungseinrichtung (ID-Knoten B) eine Vorrichtung (100) nach einem der Ansprüche 1 bis 7 aufweist.

**10.** Verfahren zur Konvertierung von Zielobjekt-Identifikationsdaten in einem Zeigerformat, das durch Zeiger auf vorab definierte und gespeicherte hierarchisch organisierte Referenzen auf Sensor- oder Quellen-spezifischen Wahrscheinlichkeitsverteilungen definiert ist, mit folgenden Schritten:

Bereitstellen (S110) einer Definitionsdatei mit zumindest einer der folgenden Informationen:

- Definition der hierarchisch organisierten Referenzen,
- Format der hierarchisch organisierten Referenzen,
- Definition von einzelnen Wahrscheinlichkeitsvektoren,
- Format von einzelnen Wahrscheinlichkeitsvektoren,
- Zuordnung der hierarchisch organisierten Referenzen zu den Wahrscheinlichkeitsvektoren,
- Zuordnung der Wahrscheinlichkeitsvektoren zu den hierarchisch organisierten Referenzen;

Konvertieren (S120) von Zielobjekt-Identifikationsdaten von einem Zeigerformat in ein Wahrscheinlichkeitsvektorformat, das durch einen oder mehrere Wahrscheinlichkeitsvektoren definiert ist, wobei die bereitgestellten Informationen zum Konvertieren genutzt werden; oder
Konvertieren (S130) von Zielobjekt-Identifikationsdaten in Form eines Wahrscheinlichkeitsvektors in das Zeigerformat, wobei die bereitgestellten Informationen zum Konvertieren genutzt werden.

**11.** Computerprogrammprodukt mit darauf gespeicherter Software, die ausgebildet ist, um das Verfahren nach Anspruch 10 auszuführen, wenn die Software auf einer Datenverarbeitungseinheit ausgeführt wird.

Zeiger → Vordefinierte Zuordnung → Deklaration

## Fig. 1

Fig. 2

Definitionsdatei
- Definition hierarchisch organisierter Zeiger
- Definition Wahrscheinlichkeitsvektoren
- Zuordnung der Zeiger zu den Wahrscheinlichkeitsvektoren

Definitions-Modul 111
Adapter 120
142
ID Knoten „A" Pointer-austausch
141
Zeiger-Fassaden-Modul
Wahrscheinlickeits vektor-Fassaden-Modul
ID Knoten „B" Wahrschein-lichkeits-Vektor
Revers-Adapter
130
100
Reversdefini-tions-Modul 112

Definitionsdatei
- Definition hierarchisch organisierter Zeiger
- Definition Wahrscheinlichkeitsvektoren
- Zuordnung der Wahrscheinlichkeitsvektoren zu den Zeigern

Fig. 3

**Flugsicherungs-System**

Flugsicherungs-Radaranlage — 411

Flugsicherungs-System — 412

ASTERIX Kommunikations-anlage — 413

ASTERIX Kommunika-tionsanlage

414

141

Definitionsdatei

Definitions-Modul

120

Zeiger-Fassaden-Modul

Adapter

Wahrschein-lickeits-vektor-Fassaden-Modul

Revers-Adapter

Reversdefinitions-Modul

**100**

Definitionsdatei

**Führungssystem (Ausschnitt)**

421

Sensor-Suite (IFF, ESM, EO, AIS, NFFI, GMTI Radar ...)

Tracking Sensordaten-Fusion — 422

Middleware z.B. CORBA

Identifizierungs-System — 423

EP 3 454 521 A1

Fig. 4

**Eigenes Führungssystem (Ausschnitt)**

- Sensor-Suite (IFF, ESM, EO, AIS, NFFI, GMTI Radar ...) — 421
- Tracking Sensordaten-Fusion — 422
- Identifizierungs-System — 423
- Wahrscheinlichkeits Vektoren

**Knoten B**

100
- 120 Definitions-Modul
- Definitionsdatei
- Adapter
- Revers-Adapter
- Umkehr-Definitions-Modul — 130
- Definitionsdatei
- 142 Wahrschein-lichkeitsvek-tor-Fassaden-Modul
- 141 Zeiger-Fassaden-Modul

**Externes angebundenes Führungssystem (Ausschnitt)**

- Sensor-Suite (IFF, ESM, EO, AIS, NFFI, GMTI Radar ...) — 512
- System — 513
- LINK-16 Prozessor — 514
- Link-16 Funk-Anlage — 515

- LINK-16 Prozessor — 530
- Link-16 Funk-Anlage — 520

**Knoten A**

Fig. 5

```
┌─────────────────────────────────────────────────────────┐
│                                                         │  ─── S110
│         Bereitstellen einer Definitionsdatei            │
│                                                         │
└─────────────────────────────────────────────────────────┘
```

S120                                                      S130

```
┌──────────────────────────────────┐  ┌──────────────────────────────────┐
│ Umwandeln von Zielidentifikations-│  │ Umwandeln einer Identifikations- │
│ informationen von einem           │  │ information in Form eines         │
│ Zeigerformat in ein Zielformat,   │  │ Wahrscheinlichkeitsvektors in     │
│ das von einem Wahrscheinlichkeits-│  │ das Zeigerformat, wobei die       │
│ vektor definiert ist, wobei die   │  │ bereitgestellten Informationen    │
│ bereitgestellten Informationen    │  │ zum Umwandeln genutzt werden      │
│ zum Umwandeln genutzt werden      │  │                                   │
└──────────────────────────────────┘  └──────────────────────────────────┘
```

Fig. 6

ID-Knoten „A" (Ausschnitt)

ID-Knoten „B" (Ausschnitt)

Sensor-Suite
(IFF, ESM, EO,
AIS, NFFI, GMTI Radar ...)

610a

System

620a

Ausgabe-
Einheit

630a

TCP/IP

Internes Datenformat
Wahrscheinlichkeits-Vektor

640a

Proprietäres Datenformat
Wahrscheinlichkeits-Vektoren

Sensor-Suite
(IFF, ESM, EO,
AIS, NFFI, GMTI Radar ...)

610b

Tracking
Sensordaten
-Fusion

622b

TCP/IP

Ausgabe-
Einheit

Identifizierungs-
System

624b

Internes Datenformat
Wahrscheinlichkeits-Vektor

640b

630b

Fig. 7

**Europäisches Patentamt**
**European Patent Office**
**Office européen des brevets**

# EUROPÄISCHER RECHERCHENBERICHT

Nummer der Anmeldung

EP 18 00 0713

## EINSCHLÄGIGE DOKUMENTE

| Kategorie | Kennzeichnung des Dokuments mit Angabe, soweit erforderlich, der maßgeblichen Teile | Betrifft Anspruch | KLASSIFIKATION DER ANMELDUNG (IPC) |
|---|---|---|---|
| Y | GB 2 542 188 A (BAE SYSTEMS PLC [GB]) 15. März 2017 (2017-03-15) * das ganze Dokument * ----- | 1-11 | INV. H04L29/06 |
| Y | EP 2 282 285 A2 (EADS DEUTSCHLAND GMBH [DE]) 9. Februar 2011 (2011-02-09) * das ganze Dokument * ----- | 1-11 | |
| Y | COX B V ET AL: "Universal noiseless and noisy data compression techniques - the state of the art", COMPUTER COMMUNICATIONS, ELSEVIER SCIENCE PUBLISHERS BV, AMSTERDAM, NL, Bd. 10, Nr. 4, 1. August 1987 (1987-08-01) , Seiten 179-188, XP026651234, ISSN: 0140-3664, DOI: 10.1016/0140-3664(87)90002-8 [gefunden am 1987-08-01] * Abschnitt "Vector quantisation" * ----- | 1-11 | |
| A | DE 10 2004 017839 A1 (DEUTSCHE TELEKOM AG [DE]) 10. November 2005 (2005-11-10) * Zusammenfassung * * Absätze [0002] - [0005], [0008] - [0029], [0043] - [0050] * ----- | 1,2,6,7, 10,11 | RECHERCHIERTE SACHGEBIETE (IPC) H04L H03M |

Der vorliegende Recherchenbericht wurde für alle Patentansprüche erstellt

| Recherchenort | Abschlußdatum der Recherche | Prüfer |
|---|---|---|
| Den Haag | 18. Januar 2019 | Kesting, Volker |

KATEGORIE DER GENANNTEN DOKUMENTE

X : von besonderer Bedeutung allein betrachtet
Y : von besonderer Bedeutung in Verbindung mit einer anderen Veröffentlichung derselben Kategorie
A : technologischer Hintergrund
O : nichtschriftliche Offenbarung
P : Zwischenliteratur

T : der Erfindung zugrunde liegende Theorien oder Grundsätze
E : älteres Patentdokument, das jedoch erst am oder nach dem Anmeldedatum veröffentlicht worden ist
D : in der Anmeldung angeführtes Dokument
L : aus anderen Gründen angeführtes Dokument
.................................................................
& : Mitglied der gleichen Patentfamilie, übereinstimmendes Dokument

EPO FORM 1503 03.82 (P04C03)

**ANHANG ZUM EUROPÄISCHEN RECHERCHENBERICHT
ÜBER DIE EUROPÄISCHE PATENTANMELDUNG NR.**

EP 18 00 0713

In diesem Anhang sind die Mitglieder der Patentfamilien der im obengenannten europäischen Recherchenbericht angeführten Patentdokumente angegeben.
Die Angaben über die Familienmitglieder entsprechen dem Stand der Datei des Europäischen Patentamts am
Diese Angaben dienen nur zur Unterrichtung und erfolgen ohne Gewähr.

18-01-2019

| Im Recherchenbericht angeführtes Patentdokument | Datum der Veröffentlichung | Mitglied(er) der Patentfamilie | Datum der Veröffentlichung |
|---|---|---|---|
| GB 2542188 A | 15-03-2017 | KEINE | |
| EP 2282285 A2 | 09-02-2011 | DE 102009035377 A1<br>EP 2282285 A2 | 03-02-2011<br>09-02-2011 |
| DE 102004017839 A1 | 10-11-2005 | DE 102004017839 A1<br>EP 1587274 A2 | 10-11-2005<br>19-10-2005 |

EPO FORM P0461

Für nähere Einzelheiten zu diesem Anhang : siehe Amtsblatt des Europäischen Patentamts, Nr.12/82